# EUROPEAN PATENT SPECIFICATION

(11) **EP 4 203 010 B1**
(45) Date of publication and mention of the grant of the patent: **30.07.2025**
(21) Application number: 20953540.0
(22) Date of filing: 15.09.2020
(51) Int. Cl.: H01L 23/31, H01L 25/07, H01L 25/18, H01L 21/60, H01L 23/498, H01L 25/16, H01L 23/051, H01L 23/053, H01L 23/433, H01L 23/40, H01L 23/373, H01L 23/495

(54) **POWER MODULE, CONVERTER, AND ELECTRONIC DEVICE**
LEISTUNGSMODUL, WANDLER UND ELEKTRONISCHE VORRICHTUNG
MODULE DE PUISSANCE, CONVERTISSEUR ET DISPOSITIF ÉLECTRONIQUE

(43) Date of publication of application: 28.06.2023
(73) Proprietor: Huawei Technologies Co., Ltd., Shenzhen, Guangdong 518129 (CN)
(72) Inventor: LUO, Wengang, Shenzhen, Guangdong 518129 (CN); HOU, Zhaozheng, Shenzhen, Guangdong 518129 (CN); WANG, Junhe, Shenzhen, Guangdong 518129 (CN)
(74) Representative: Isarpatent
(86) International application number: PCT/CN2020/115360
(87) International publication number: WO 2022/056679

(56) References cited:
- CN-A- 101 494 175
- CN-A- 106 684 076
- CN-U- 211 209 596
- JP-B2- 5 962 364
- US-A1- 2005 167 849
- US-A1- 2017 018 488
- US-A1- 2017 018 524

## Description

### TECHNICAL FIELD

This disclosure generally relates to the field of chip packaging technologies, and the invention in particular relates to a power module, a converter, and an electronic device.

### BACKGROUND

A power module is a module obtained by combining and packaging electronic power devices based on specific functions. In the conventional technology, a power module is connected to a drive board, and a switch of a power chip packaged in the power module is controlled by using the drive board. However, in the conventional technology, a parasitic parameter between the drive board and the power chip in the power module is excessively large, affecting electrical performance of the power module.

US 2017/018524 A1 discloses a semiconductor device that includes a plurality of semiconductor units each including a laminated substrate formed by laminating an insulating board and a circuit board and a semiconductor element joined to the circuit board using a joining material which irreversibly makes a phase transition into a solid-phase state. In addition, the semiconductor device may include a base plate to which each of the plurality of semiconductor units is joined using solder and a connection unit which electrically connects the plurality of semiconductor units in parallel.

JP 5 962364 B2 describes challenges associated with different thermal expansion coefficients in a power semiconductor module. In particular, when post electrodes of the printed circuit board are joined to the semiconductor chip by an electrical bonding material such as solder, issues arise due to the different linear expansion coefficients. When the semiconductor chip generates heat during operation or the ambient temperature rises, this difference in coefficients leads to thermal stresses. Resultantly, the post electrodes are subjected to forces that pull them in an up-and-down motion. It is described that this can cause the semiconductor chip to become damaged or deformed under extreme conditions, threatening the module's reliability. To solve this problem, the document describes two main improvements. By reducing the length of the post electrodes, the force acting on the semiconductor chip due to the linear expansion coefficient difference is reduced. A higher bending rigidity in the printed circuit board has the benefit that the board will not deform significantly under the stress due to thermal expansion from solder or other bonding materials. This stiffness in the board helps to further suppress the force acting on the post electrodes that connect to the semiconductor chip and minimizes the risk of damage to the semiconductor chip.

### SUMMARY

The object of the present invention is to provide a power module, a converter, and an electronic device to reduce a parasitic parameter between a drive board and the power module, and improve electrical performance of the power module and the claimed invention is disclosed by the subject matter of present independent product claim 1 and its dependent claims 2-8.

### BRIEF DESCRIPTION OF DRAWINGS

FIG. 1 is a schematic diagram of a structure of an electronic device;
FIG. 2 is a schematic diagram of a partial structure of a converter of the electronic device shown in FIG. 1 according to the invention;
FIG. 3 is a schematic diagram of a structure of a first embodiment of a power module of the converter shown in FIG. 2 according to the invention;
FIG. 4 is a schematic diagram of a structure of another implementation of the power module shown in FIG. 3 according to the invention;
FIG. 5 is a schematic diagram of a structure of a second embodiment of the power module shown in FIG. 2 according to the invention;
FIG. 6 is a schematic diagram of a structure of a third embodiment not according to the invention of the power module shown in FIG. 2;
FIG. 7 is a schematic diagram of a structure of a fourth embodiment not according to the invention of the power module shown in FIG. 2;
FIG. 8 is a schematic flowchart of a manufacturingmethod, which is not claimed within the claimed invention, for the power module shown in FIG. 3 according to the invention; and
FIG. 9 to FIG. 21 are specific schematic flowcharts of the manufacturing method shown in FIG. 8 in figure 18 is useful for understanding the invention (but does not fall within the scope of the claimed invention) and figure 19 is which an embodiment according to the claimed invention. The embodiments depicted within figures 9-17 and 20-21 do not fall within the scope of the claimed invention.

### DESCRIPTION OF EMBODIMENTS

The following describes embodiments of this application with reference to accompanying drawings in embodiments of this application.

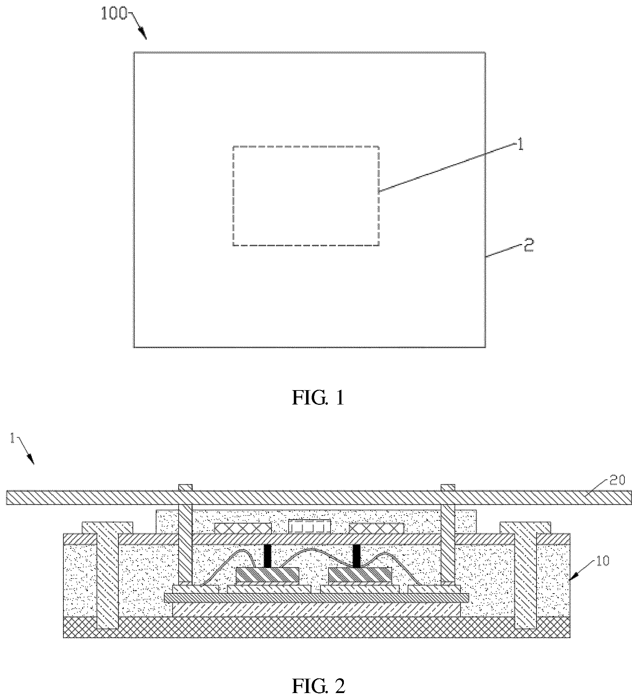

FIG. 1 is a schematic diagram of a structure of an electronic device 100.

The electronic device 100 includes a converter 1 and a housing 2. The converter 1 is accommodated in the housing 2, and the converter 1 is configured to convert an electrical signal of the electronic device 100. The electronic device 100 in this embodiment includes but is not limited to an electronic device 100 with the converter 1, such as a wind turbine, a photovoltaic generator, an electric vehicle, and a major appliance. Integration and electrical performance of the electronic device 100 with the converter 1 provided in this application are effectively improved.

FIG. 2 is a schematic diagram of a partial structure of the converter 1 of the electronic device 100 shown in FIG. 1 according to the invention.

The converter 1 includes a power module 10 and a circuit board 20. The power module 10 is mounted to the circuit board 20, and the circuit board 20 is electrically connected to the power module 10 to control the power module 10. The converter 1 in this embodiment includes but is not limited to a converter with the power module 10, such as a direct current-to-alternating current converter and a direct current-to-direct current converter. Integration and electrical performance of the converter 1 with the power module 10 provided in this application are effectively improved.

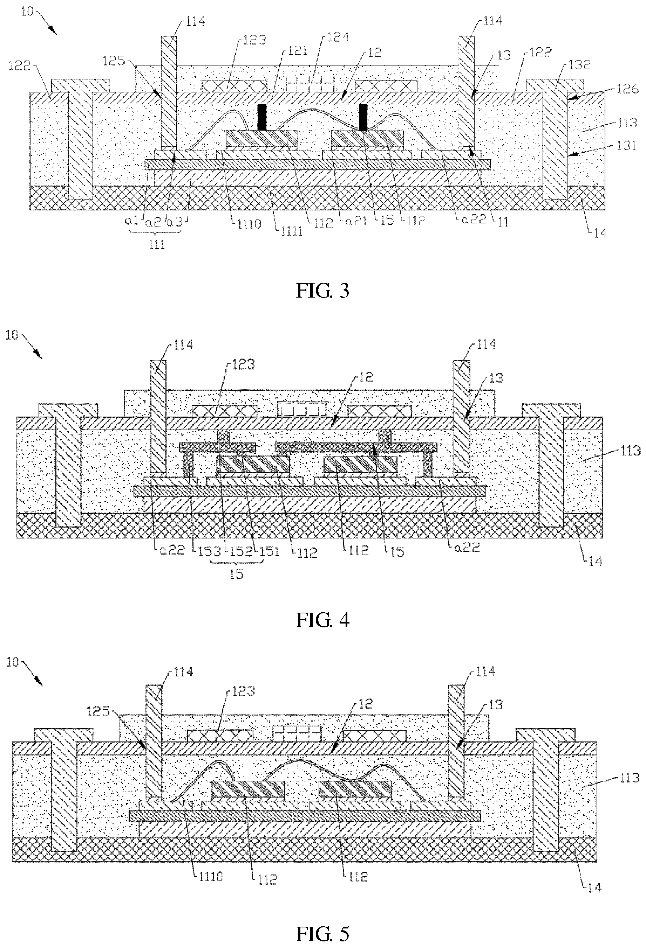

FIG. 3 is a schematic diagram of a structure of a first embodiment of the power module 10 of the converter 1 shown in FIG. 2 according to the invention.

The power module 10 includes a power assembly 11 and a drive board 12. The power assembly 11 includes a substrate 111, a power chip 112, and a package body 113. The power chip 112 is disposed on a mounting surface 1110 of the substrate 111. The package body 113 packages the power chip 112 on the substrate 111. The drive board 12 is disposed in the package body 113 and is located on a side, of the power chip 112, that backs the mounting surface 1110, to form a packaged structure 13 with the power assembly 11. The drive board 12 is electrically connected to the power chip 112, to drive the power chip 112 to operate. It is understood that the package body 113 packages the drive board 12 and the power chip 112 on the substrate 111, to form the packaged structure 13.

In the power module 10 in this embodiment, the drive board 12 is disposed in the package body 113 of the power assembly 11, and the drive board 12 is located on the side, of the power chip 112, that backs the mounting surface 1110, to reduce a distance between the drive board 12 and the power chip 112. Further, a connection line between the power chip 112 and the drive board 12 is shortened, thereby effectively reducing a parasitic parameter of the connection line between the power chip 112 and the drive board 12, that is, reducing a parasitic parameter of the power module 10, and improving electrical performance of the power module 10. In addition, the drive board 12 is disposed in the package body 113 of the power assembly 11, that is, the drive board 12 is disposed inside the power assembly 11. Compared with disposing the drive board 12 and the power assembly 11 on a same plane, this can effectively reduce a planar area of the power module 10. When the package body 113 is formed for the power assembly 11, to ensure strength of the power assembly 11, a thickness of the power assembly 11 is usually greater than 5 mm. This thickness is sufficient to allow the drive board 12 to be embedded in the package body 113 of the power assembly 11, without increasing the thickness of the power assembly 11. That is, disposing the drive board 12 in the package body 113 does not affect the thickness of the power assembly 11, thereby effectively improving integration of the power module 10, reducing a package size and reducing costs of the power module 10.

It may be understood that there are mainly two parasitic parameters: a parasitic inductance and a parasitic resistance. A magnitude of the parasitic inductance is mainly affected by two factors: a length of the connection line, where a longer connection line results in a larger parasitic inductance; and an area surrounded by the connection line, where a larger area surrounded by the connection line results in a larger parasitic inductance. For the parasitic resistance, a longer connection line results in a larger parasitic resistance. Therefore, in this application, a shorter distance between the drive board 12 and the power chip 112 indicates a shorter connection line between the drive board 12 and the power chip 112, and an area surrounded by the connection line is also reduced, thereby effectively reducing a parasitic inductance and a parasitic resistance of the power module 10, and improving electrical performance of the power module 10.

The substrate 111 includes a bearing plate a1, a line layer a2, and a metal layer a3. The line layer a2 and the metal layer a3 are respectively formed on two opposite surfaces of the bearing plate a1, and the line layer a2 and the metal layer a3 are respectively located on two sides of the bearing plate a1, to ensure flatness of the bearing plate a1 and prevent warpage of the bearing plate a1. A surface, of the line layer a2, that backs the bearing plate a1 is the mounting surface 1110, that is, the power chip 112 is disposed on the surface, of the line layer a2, that backs the bearing plate a1. A surface, of the substrate 111, that backs the power chip 112 is a rear surface 1111, that is, a surface, of the metal layer a3, that backs the bearing plate a1 is the rear surface 1111, and the rear surface 1111 is exposed from the package body 113. The line layer a2 may be configured to implement an electrical connection between the power chip 112 and another device, or may be configured to implement an electrical connection between power chips 112. Because the rear surface 1111 of the metal layer a3 is exposed from the package body 113, the metal layer a3 can effectively transmit heat of the power chip 112 to the outside, thereby improving heat dissipation efficiency of the power chip 112. In addition, the metal layer a3 can further effectively enhance strength of the substrate 111.

In this embodiment, the bearing plate a1 may be made of an insulation and heat dissipation material such as ceramic. The ceramic may be, for example, a ceramic material such as aluminum oxide, silicon nitride, or aluminum nitride. The ceramic material has good heat dissipation effect, and can quickly dissipate heat for the power chip 112. The line layer a2 and the metal layer a3 are made of a metal material, for example, a copper, nickel, or aluminum material, and can quickly dissipate heat for the power chip 112. The line layer a2 and the metal layer a3 may be made of a same material or different materials. In addition, the line layer a2 is further configured to implement an electrical connection between the power chip 112 and another line. Certainly, in another embodiment, the bearing plate a1 may be alternatively made of another insulation material.

In this embodiment, the line layer a2 includes a first line a21 and a second line a22. Second lines a22 are located on two sides of the first line a21. Surfaces, of the first line a21 and the second line a22, that back the bearing plate a1 jointly constitute the mounting surface 1110. The power chip 112 is disposed on the first line a21, and the power chip 112 is connected to the second line a22 through a lead. Certainly, the power chip 112 may be alternatively connected to the second line a22 by using another conducting structure, and the second line a22 is connected to another element. That is, the second line a22 is configured to implement a connection between the power chip 112 and the another element. Certainly, in another embodiment, a structure of the line layer a2 is not limited to the foregoing descriptions, and a specific structure of the line layer a2 may be arranged according to a connection requirement of the power chip 112.

In this embodiment, there are one or more power chips 112. In FIG. 3, for example, there are two power chips 112. The two power chips 112 are disposed on the first line a21 at a spacing, and the two power chips 112 are electrically connected through a lead. A lead connection process is mature and simple, and has low costs. The power chip 112 may be an insulated gate bipolar transistor (IGBT), a metal-oxide semiconductor field-effect transistor (MOSFET), and/or a diode. The power chip 112 may be fastened to the first line a21 through welding, bonding, or the like. For example, when the power chip 112 needs to be electrically connected to the first line a21, the power chip 112 may be fastened to the first line a21 through welding. When the power chip 112 does not need to be electrically connected to the first line a21, the power chip 112 may be fastened to the first line a21 in another manner such as bonding. Certainly, in another embodiment, the two power chips 112 may be alternatively connected by using a connection structure such as a lead frame.

The package body 113 according to the invention is formed by using a plastic packaging process. The package body 113 is made of a plastic material such as epoxy resin or silicone. The package body 113 formed by using the plastic packaging process has good sealing performance, so that moisture resistance and reliability of the packaged structure 13 can be improved. Specifically, the package body 113 is packaged in a region from the rear surface 1111 of the substrate 111 to a side, of the drive board 12, that backs the power chip 112, and no package body 113 is disposed at an edge of the side, of the drive board 12, that backs the power chip 112, thereby facilitating fitting between the power chip 112 and a related structure. In another embodiment, the package body 113 may be alternatively formed by using another process such as a housing packaging process. It should be noted that whenever in this disclosure there is a reference that a package body is not using plastic packaging, this packaging body does not fall within the scope of the claimed invention.

The power assembly 11 further includes a pin 114. The pin 114 penetrates the drive board 12 and a part of the package body 113. One end of the pin 114 is disposed on the mounting surface 1110 and is electrically connected to the power chip 112, and the other end of the pin 114 is exposed from the package body 113. Specifically, the pin 114 is disposed on a second line a22 corresponding to the pin 114, so that the pin 114 is electrically connected, through the second line a22, to a power chip 112 corresponding to the pin 114. The pin 114 is configured to implement an electrical connection between the power chip 112 and the circuit board 20 (FIG. 2). Certainly, in another embodiment, the pin 114 of the power chip 112 may be alternatively configured to implement an electrical connection between the power chip 112 and the drive board 12. Alternatively, the pin 114 may not penetrate the drive board 12. Alternatively, the power chip 112 may be connected to the circuit board 20 by using a structure other than the pin 114.

In a direction perpendicular to the mounting surface 1110, a distance between the drive board 12 and the power chip 112 is less than a distance between the drive board 12 and a surface, of the package body 113, that backs the mounting surface 1110. In this embodiment, the distance between the drive board 12 and the power chip 112 is required to be less than the distance between the drive board 12 and the surface, of the package body 113, that backs the mounting surface 1110, to ensure that the distance between the drive board 12 and the power chip 112 is sufficiently short, thereby ensuring that the parasitic parameter of the connection line between the drive board 12 and the power chip 112 is sufficiently small, and effectively improving electrical performance of the power module 10.

In this embodiment, there are two pins 114, and the two pins 114 are respectively disposed on second lines a22 on two sides of the two power chips 112. In other words, the two power chips 112 are disposed between the two pins 114. The pin 114 may be welded to a second line a22 corresponding to the pin 114 by using solder paste, or may be fastened to a second line a22 corresponding to the pin 114 through ultrasonic welding, silver sintering, or the like. A shape of the pin 114 may be a cylindrical shape, an elliptic cylindrical shape, a cuboid shape, a polygonal shape, or the like. Shapes of the two pins 114 may be the same or different. A material of the pin 114 may be a metal or an alloy with good conductivity, for example, Cu, Ag, or Al. Certainly, in another embodiment, an arrangement manner of the power chip 112 and the pin 114 and a quantity of pins 114 may be alternatively arranged according to an actual requirement.

According to the invention, the drive board 12 includes a center region 121 and an edge region 122 surrounding the center region 121. The center region 121 is arranged opposite to the power assembly 11. Electronic elements such as a drive chip 123, a resistor 124, a capacitor, and an optocoupler are disposed in the center region 121 to form a drive circuit. The power chip 112 of the power assembly 11 is electrically connected to the drive chip 123. The packaged structure 13 includes a mounting hole 131. The mounting hole 131 is located in the edge region 122, and penetrates the drive board 12 and the package body 113 in a direction from the drive board 12 to the power chip 112. A related component is connected to the packaged structure 13 through the mounting hole. The edge region 122 and the package body 113 located in the edge region 122 may be understood as a mounting part of the packaged structure 13, so that the packaged structure 13 is fastened to another component by using the mounting part.

Certainly, in an implementation scenario of another embodiment which does not fall within the scope of the claimed invention, a related component may be alternatively fastened to the packaged structure 13 by using a screw or in another fastening manner. In another implementation scenario of another embodiment which does not fall within the scope of the claimed invention, the packaged structure 13 may be alternatively fastened to a related component in another connection manner such as bonding or clamping. In still another implementation scenario of another embodiment which does not fall within the scope of the claimed invention, small electronic elements such as the resistor 124, the capacitor, and the optocoupler may be alternatively partially disposed in the edge region 122. In yet another implementation scenario of another embodiment which does not fall within the scope of the claimed invention, when the drive board 12 does not need to be fastened to a related component, the drive board 12 may alternatively include only the center region 121, that is, the drive board 12 may not include the edge region 122.

According to the invention, a surface, of the edge region 122, that backs the power chip 112 is exposed from the package body 113, that is, no package body 113 is disposed on the surface, of the edge region 122, that backs the power chip 112, so that a screw 132 is fastened through the surface, of the edge region 122, that backs the power chip 112. In addition, the package body 113 is made of a brittle material, and the package body 113 is prone to breakage under large stress. Because no package body 113 is disposed in the edge region 122, the screw 132 directly transmits a locking force to the drive board 12, thereby reducing the stress applied to the package body 113, and avoiding a risk that the package body 113 cracks because the screw 132 directly transmits the locking force to the package body 113.

The drive board 12 further includes a through hole 125. The through hole 125 is configured to allow a pin 114 corresponding to the drive board 12 to pass through, so that the pin 114 penetrates the drive board 12 and is connected to a related external element. In this embodiment, the pin 114 passes through the through hole 125 and is not electrically connected to the through hole 125. Certainly, in another embodiment, the pin 114 may be alternatively electrically connected to the drive board 12 through the through hole 125, to implement an electrical connection between the drive board 12 and the power chip 112.

The power module 10 further includes a heat sink 14, and the heat sink 14 is fastened to the packaged structure 13 and is in contact with the rear surface 1111. Specifically, the screw 132 is connected to the heat sink 14 through the mounting hole 131, to fasten the heat sink 14 to the packaged structure 13. The rear surface 1111 of the substrate 111 is in direct contact with the heat sink 14, so that heat of the power chip 112 can be quickly transmitted to the heat sink 14 and then transmitted by the heat sink 14 to the outside, thereby effectively improving heat dissipation efficiency of the power chip 112.

The power module 10 further includes a conductor 15. The conductor 15 is located between the power chip 112 and the drive board 12. The power chip 112 is connected to the drive board 12 through the conductor 15. Specifically, the drive chip 123 on the drive board 12 is connected to the power chip 112 of the power assembly 11 through the conductor 15. Because the drive board 12 is disposed in the package body 113 of the power assembly 11, the distance between the drive board 12 and the power chip 112 is reduced. Further, the connection line (the conductor 15) connected between the drive board 12 and the power chip 112 is shortened, thereby effectively reducing the parasitic parameter of the connection line of the power module 10, and improving electrical performance of the power module 10.

The conductor 15 in this embodiment may be implemented in a plurality of manners. Details are described below.

In an implementation, as shown in FIG. 3, the conductor is a copper rod 15, and two ends of the copper rod 15 are respectively electrically connected to the power chip 112 and the drive board 12. Specifically, the two ends of the copper rod 15 are electrically connected to the power chip 112 and the drive chip 123 on the drive board 12. A quantity of copper rods 15 corresponds to a quantity of power chips 112, and one copper rod 15 corresponds to one power chip 112. A length of the copper rod 15 is equal to the distance between the drive board 12 and the power chip 112. It may be understood that a length direction of the copper rod 15 is a flow direction of a current in the copper rod 15, so that the length of the copper rod 15 is the shortest, thereby effectively reducing the parasitic parameter of the connection line of the power module 10, and improving electrical performance of the power module 10. Certainly, in another embodiment, the power chip 112 may be alternatively connected to the drive board 12 by using another conducting structure such as a lead.

FIG. 4 is a schematic diagram according to the invention of a structure of another implementation of the power module 10 shown in FIG. 3 according to the invention.

In another not claimed implementation, the conductor is a lead frame (Lead Frame, LF) 15. The lead frame 15 includes a first terminal 151 and a second terminal 152 that are connected to each other. The first terminal 151 is electrically connected to the power chip 112. The second terminal 152 is electrically connected to the drive board 12. Specifically, the second terminal 152 is electrically connected to the drive chip 123 on the drive board 12. A quantity of lead frames 15 corresponds to a quantity of power chips 112. In this implementation, the lead frame 15 has a quite good through-current capability, thereby effectively reducing the parasitic parameter of the power module 10, and effectively improving a heat dissipation capability of the power chip 112. In addition, two power chips 112 may also be electrically connected through the lead frame, thereby effectively reducing manufacturing steps of the power module 10, and improving production efficiency of the power module 10.

The lead frame 15 further includes a not claimed third terminal 153 electrically connected to the first terminal 151, and the third terminal 153 is electrically connected to the pin 114. Specifically, the third terminal 153 is electrically connected to the second line a22, so as to be electrically connected to the pin 114. That is, the lead frame 15 in this implementation can also implement an electrical connection between the pin 114 and the power chip 112, so that no additional lead needs to be introduced to connect the power chip 112 and the pin 114. Therefore, a structure of the power module 10 is simpler, and manufacturing steps of the power module 10 are reduced, thereby improving production efficiency of the power module 10. In addition, compared with a lead, the lead frame 15 has a stronger through-current capability and a smaller parasitic parameter, so that heat dissipation effect of the power chip 112 can be further improved.

FIG. 5 is a schematic diagram according to the invention of a structure of a second embodiment of the power module 10 shown in FIG. 2 according to the invention.

The structure of the power module 10 in this embodiment is approximately the same as that in the first embodiment. A difference lies in that, in this embodiment, the power chip 112 is electrically connected to the drive board 12 through the pin 114, and the pin 114 is electrically connected to the drive board 12, so that the drive board 12 is electrically connected to the power chip 112. Specifically, the pin 114 is electrically connected to a hole wall of the through hole 125 when penetrating the drive board 12 through the through hole 125, and the hole wall of the through hole 125 is electrically connected to the drive chip 123 on the drive board 12. An end, of the pin 114, that is away from the mounting surface 1110 is further connected to the circuit board 20 (FIG. 2). That is, the pin 114 can implement an electrical connection between the power chip 112 and the drive chip 123 on the drive board 12, and can also implement an electrical connection between the power chip 112 and the external circuit board 20, thereby simplifying a structure of the power module 10. Certainly, in another embodiment, the pin 114 may be alternatively configured to implement only an electrical connection between the power chip 112 and the drive chip 123 on the drive board 12.

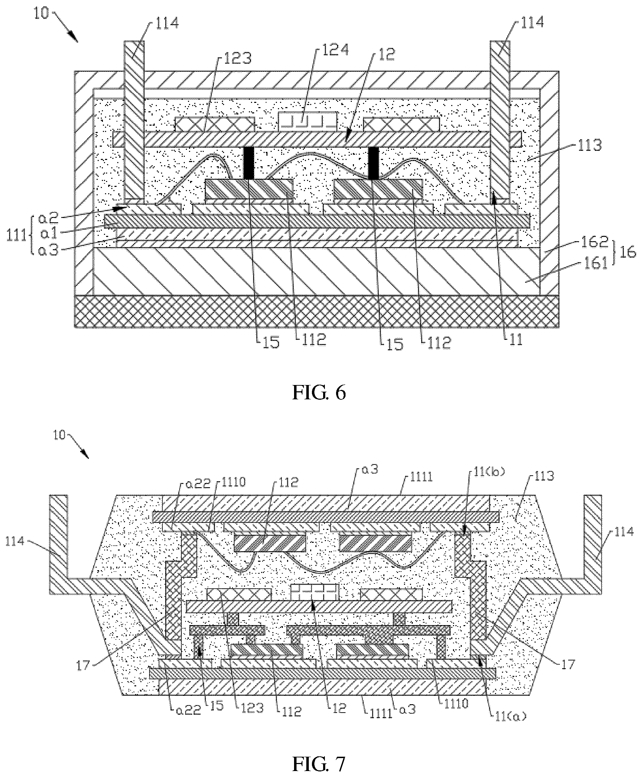

FIG. 6 is a schematic diagram of a structure of a third embodiment, which does not fall within the scope of the claimed invention, of the power module 10 shown in FIG. 2.

The structure of the power module 10 in this embodiment is approximately the same as that in the first embodiment. A difference lies in that, in this embodiment, the power module 10 further includes a not claimed package housing 16. The power assembly 11 and the drive board 12 are accommodated in the package housing 16. An end, of the pin 114, that backs the power chip 112 extends out of the package housing 16. The package body 113 is injected into a gap in the package housing 16 by using a housing packaging process. Specifically, a packaging material such as silicon gel or epoxy resin is injected into the package housing 16 to form the package body 113. In this application, the package body 113 is formed by using the housing packaging process. The process is simple, thereby effectively improving production efficiency of the power module 10.

The package housing 16 includes a base plate 161 and a cover 162. The cover 162 covers the base plate 161, and forms a space for accommodating the power assembly 11 and the drive board 12 with the base plate 161. Specifically, the metal layer a3 of the substrate 111 is fastened to the base plate 161 through welding, and an end, of the pin 114, that backs the power chip 112 extends out of the cover 162. In this embodiment, the metal layer a3 is fastened to the base plate 161 through welding. While ensuring strength of the connection between the substrate 111 and the base plate 161, this helps quickly transmit, to the base plate 161, heat transmitted from the power chip 112 to the substrate 111, so that the heat is transmitted to the outside through the base plate 161, thereby effectively improving heat dissipation efficiency of the power module 10. Certainly, the metal layer a3 of the substrate 111 may be alternatively fastened to the base plate 161 in another connection manner such as bonding or clamping.

In this embodiment, a lead is used to connect the two power chips 112 and connect the power chip 112 to the pin 114, and the power chip 112 is connected to the drive board 12 through the copper rod 15. Certainly, the power chip 112 may be alternatively connected to the drive board 12 through the lead. In addition, a lead frame 15 may be used to connect the two power chips 112, connect the power chip 112 to the pin 114, and connect the power chip 112 to the drive board 12.

The drive board 12 in this embodiment includes only a center region 121. Electronic elements such as a drive chip 123, a resistor 124, a capacitor, and an optocoupler are disposed in the center region 121 to form a drive circuit. The power chip 112 of the power assembly 11 is electrically connected to the drive chip 123.

The heat sink 14 is fastened to the base plate 161, and is in contact with a surface, of the base plate 161, that backs the substrate 111, so that the base plate 161 quickly transmits heat of the power chip 112 to the outside through the heat sink 14, thereby improving heat dissipation efficiency of the power chip 112, and further improving electrical performance of the power module 10. Specifically, the heat sink 14 may be fastened to the base plate 161 in one of connection manners such as screwing, clamping, and bonding. Certainly, in another embodiment, the power module in this embodiment may be alternatively not provided with a heat sink.

FIG. 7 is a schematic diagram of a structure of a fourth embodiment, which does not fall within the scope of the claimed invention, of the power module 10 shown in FIG. 2.

The structure of the power module 10 in this embodiment is approximately the same as that in the first embodiment. A difference lies in that there are two power assemblies 11 in this embodiment. Mounting surfaces 1110 of the two power assemblies 11 are arranged opposite to each other and are electrically connected to each other. Package bodies 113 of the two power assemblies 11 are connected. The drive board 12 is disposed between the two power assemblies 11 and is electrically connected to at least one power assembly 11. It may be understood that the drive board 12 may be embedded in a package body 113 of any one of the power assemblies 11; or the drive board 12 may be embedded between the package bodies 113 of the two power assemblies 11, to be specific, a part of the drive board 12 is embedded in a package body 113 of one power assembly 11, and the other part is embedded in a package body 113 of the other power assembly 11.

In this embodiment, the drive board 12 is embedded between the two power assemblies 11, to shorten distances between the drive board 12 and power chips 112 of the two power assemblies 11, and further shorten connection lines between the drive board 12 and the power chips 112 of the two power assemblies 11, thereby effectively reducing parasitic parameters of the connection lines, and improving electrical performance of the power module 10. In addition, surfaces, of metal layers a3 of the two power assemblies 11, that back the drive board 12 are both exposed from the package body 113, to dissipate heat for the power chips 112 corresponding to the two power assemblies 11, thereby improving heat dissipation efficiency of the power chips 112, and effectively improving electrical performance of the power module 10.

In this embodiment, as shown in FIG. 7, for ease of differentiation, the two power assemblies 11 are a power assembly 11a and a power assembly 11b, and the power assembly 11a is electrically connected to the drive board 12. Specifically, a power chip 112 of the power assembly 11a is connected to the drive chip 123 on the drive board 12 through the lead frame 15. Certainly, the power chip 112 of the power assembly 11a may be alternatively connected to the drive chip 123 on the drive board 12 by using a conducting structure such as a lead or a metal rod. In another embodiment, the drive board 12 may be alternatively electrically connected to the power chips 112 of the two power assemblies 11. In addition, the drive board 12 may be connected to the power assembly 11a and the power assembly 11b in a same manner or different manners.

The power module 10 includes a conducting rod 17 and a pin 114. Two ends of the conducting rod 17 are respectively connected to a mounting surface 1110 of the power assembly 11a corresponding to the conducting rod 17 and a mounting surface 1110 of the power assembly 11b corresponding to the conducting rod 17. Specifically, the two ends of the conducting rod 17 are respectively connected to a second line a22 of the power assembly 11a corresponding to the conducting rod 17 and a second line a22 of the power assembly 11b corresponding to the conducting rod 17, and are respectively electrically connected to the power chip 112 of the power assembly 11a and the power chip 112 of the power assembly 11b. One end of the pin 114 is fastened to the conducting rod 17 of the second line a22 of the power assembly 11a, and the other end of the pin 114 extends out of a side of a package body 113 of the power assembly 11a and/or a package body 113 of the power assembly 11b, to connect to a related external device, for example, a circuit board. As shown in FIG. 7, there are two conducting rods 17 and two pins 114, the two conducting rods 17 are respectively located on two sides of the two power chips 112, and the two pins 114 respectively extend out of the package body 113 from two sides of the package body 113. In this application, the conducting rod 17 is configured to implement an electrical connection between the power assembly 11a and the power assembly 11b, and the pin 114 is configured to connect the power assembly 11a and the power assembly 11b to an external device. Certainly, in another embodiment, quantities and specific structures of pins 114 and conducting rods 17 are not limited to the foregoing descriptions.

In this embodiment, the lead frame 15 is used to connect two power chips 112 of the power assembly 11a, and connect the power chips 112 to the conducting rods 17. A lead is used to connect two power chips 112 of the power assembly 11b, and connect the power chips 112 to the conducting rods 17. Certainly, a lead or another conducting structure may be alternatively used to connect the two power chips 112 of the power assembly 11a, and connect the power chips 112 to the conducting rods 17. The lead frame 15 or another conducting structure may be alternatively used to connect the two power chips 112 of the power assembly 11b, and connect the power chips 112 to the conducting rods 17.

The package body 113 of the power assembly 11a and the package body 113 of the power assembly 11b are integrated, so that connection strength of the packaged structure 13 including the power assembly 11a, the power assembly 11b, and the drive board 12 is higher. Specifically, the package body 113 of the power assembly 11a and the package body 113 of the power assembly 11b form an integrally molded package body 113 by using a plastic packaging process. Certainly, the package body 113 of the power assembly 11a and the package body 113 of the power assembly 11b may be alternatively formed by using a housing packaging process.

The protection scope of this application is not limited to the first embodiment to the fourth embodiment, and any combination of the first embodiment to the fourth embodiment also falls within the protection scope of this application. That is, the foregoing plurality of embodiments may be alternatively combined according to an actual requirement.

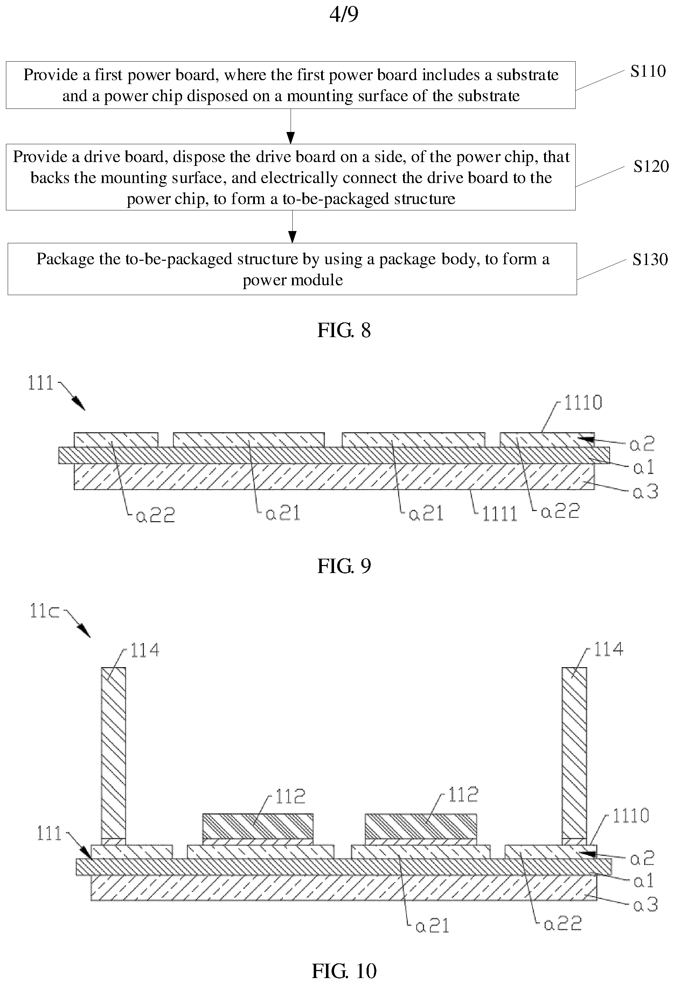

FIG. 8 is a schematic flowchart of a manufacturing method, which does not fall within the scope of the claimed invention, for the power module shown in FIG. 3. As shown in FIG. 8, the manufacturing method for the power module includes S110 to S130.

S110: Provide a first power board, where the first power board includes a substrate 111 and a power chip 112 disposed on a mounting surface 1110 of the substrate 111.

Specifically, as shown in FIG. 9 to FIG. 12, all of which are not falling within the scope of the claimed invention, specific steps of providing the first power board 11c are as follows: First, as shown in FIG. 9, the substrate 111 is provided. The substrate 111 includes a bearing plate a1, a line layer a2, and a metal layer a3. The line layer a2 and the metal layer a3 are respectively formed on two opposite surfaces of the bearing plate a1, and the line layer a2 and the metal layer a3 are respectively located on two sides of the bearing plate a1, to ensure flatness of the bearing plate a1 and prevent warpage of the bearing plate a1. A surface, of the line layer a2, that backs the bearing plate a1 is the mounting surface 1110, that is, the power chip is disposed on the surface, of the line layer a2, that backs the bearing plate a1. A surface, of the substrate 111, that backs the power chip is a rear surface 1111, that is, a surface, of the metal layer a3, that backs the bearing plate a1 is the rear surface 1111. The line layer a2 includes a first line a21 and a second line a22. Second lines a22 are located on two sides of the first line a21. Surfaces, of the first line a21 and the second line a22, that back the bearing plate a1 jointly constitute the mounting surface 1110. Certainly, in another embodiment, a structure of the line layer a2 is not limited to the foregoing structure, and a specific structure of the line layer a2 may be arranged according to a connection requirement of the power chip.

In this embodiment, the bearing plate a1 may be made of an insulation and heat dissipation material such as ceramic. The ceramic may be, for example, a ceramic material such as aluminum oxide, silicon nitride, or aluminum nitride. The ceramic material has good heat dissipation effect, and can quickly dissipate heat for the power chip disposed on the substrate 111 in a subsequent process. The line layer a2 and the metal layer a3 are made of a metal material, for example, a copper, nickel, or aluminum material, can quickly dissipate heat for the power chip disposed on the substrate 111 in the subsequent process, and can further effectively enhance strength of the substrate 111. The line layer a2 and the metal layer a3 may be made of a same material or different materials. In addition, the line layer a2 is further configured to implement an electrical connection between the power chip disposed on the substrate 111 in the subsequent process and another line. Certainly, in another embodiment, the bearing plate a1 may be alternatively made of another insulation material.

Then, as shown in FIG. 10, the power chip 112 is provided. The power chip 112 may be an insulated gate bipolar transistor (IGBT), a metal-oxide semiconductor field-effect transistor (MOSFET), and/or a diode. Certainly, in another embodiment, the power chip 112 may be provided before the substrate 111 Alternatively, the substrate 111 and the power chip 112 may be provided simultaneously.

Then the power chip 112 is disposed on the mounting surface 1110 of the substrate 111. Specifically, soldering tin is printed on the first line a21, and then the power chip 112 is welded to the first line a21. In this embodiment, there are two power chips 112. The two power chips 112 are disposed on the first line a21 at a spacing. Certainly, in another embodiment, one or more power chips 112 may be alternatively welded to the first line a21. Alternatively, the power chip 112 may be fastened to the first line a21 through welding, bonding, or the like based on different conditions. For example, when the power chip 112 needs to be electrically connected to the first line a21, the power chip 112 may be fastened to the first line a21 through welding. When the power chip 112 does not need to be electrically connected to the first line a21, the power chip 112 may be fastened to the first line a21 in another manner such as bonding.

When the power chip 112 is disposed on the mounting surface 1110 of the substrate 111, a pin 114 is fastened to the mounting surface 1110. First, soldering tin is printed on both the first line a21 and the second line a22. Then the power chip 112 is welded to the first line a21, and the pin 114 is welded to the second line a22 at the same time. Specifically, there are two pins 114, and the two pins 114 are respectively welded to second lines a22 on two sides of the two power chips 112. In this embodiment, the pin 114 is perpendicular to the mounting surface 1110. Alternatively, the pin 114 may be fastened to a second line a22 corresponding to the pin 114 through welding by using solder paste, ultrasonic welding, silver sintering, or the like. A shape of the pin 114 may be a cylindrical shape, an elliptic cylindrical shape, a cuboid shape, a polygonal shape, or the like. Shapes of the two pins 114 may be the same or different. A material of the pin 114 may be a metal or an alloy with good conductivity, for example, Cu, Ag, or Al. Certainly, a quantity and an arrangement manner of pins 114 may be alternatively arranged according to an actual requirement. Alternatively, the pin 114 may not be perpendicular to the mounting surface 1110.

In this embodiment, the power chip 112 and the pin 114 are simultaneously mounted to the mounting surface 1110. This helps reduce manufacturing steps of the power module, reduce production costs, and improve production efficiency of the power module. In another embodiment, alternatively, the power chip 112 may be mounted to the mounting surface 1110 before the pin 114, or the pin 114 may be mounted to the mounting surface 1110 before the power chip 112.

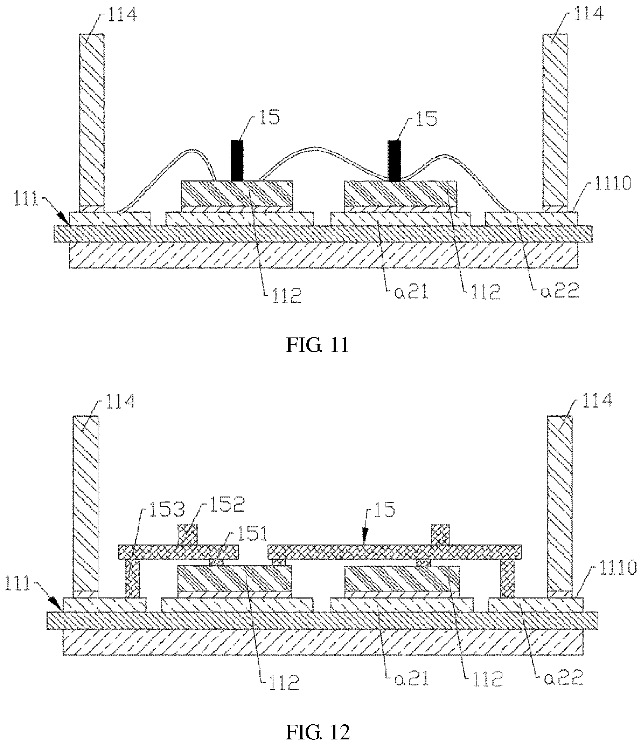

Then, as shown in FIG. 11 and FIG. 12, a conductor 15 electrically connected to the power chip 112 is formed on a surface, of the power chip 112, that backs the mounting surface 1110, and the conductor 15 is configured to electrically connect the power chip 112 to a related element mounted in a subsequent process. Specifically, steps of forming the conductor 15 may be implemented in a plurality of manners. Details are described as follows.

In an implementation, as shown in FIG. 11, when the conductor is a copper rod 15, before the conductor 15 is formed on the surface, of the power chip 112, that backs the mounting surface 1110, first, the two power chips 112 are electrically connected, and the power chip 112 is electrically connected to a pin 114 corresponding to the power chip 112. The two power chips 112 are connected through a lead, and the power chip 112 is indirectly electrically connected to the pin 114 corresponding to the power chip 112. Specifically, the lead is connected between the second line a22 and the power chip 112, so that the power chip 112 is indirectly electrically connected to the pin 114 corresponding to the power chip 112. A lead connection process is mature and simple, and has low costs. Certainly, in another embodiment, a connection structure such as a lead frame may be alternatively used to connect the two power chips 112, and connect the power chip 112 to the pin 114 corresponding to the power chip 112. Then one end of the copper rod 15 is fastened to the surface, of the power chip 112, that backs the mounting surface 1110, and is electrically connected to the power chip 112. A quantity of copper rods 15 corresponds to a quantity of power chips 112, and one copper rod 15 corresponds to one power chip 112. Certainly, in another embodiment, the conductor 15 may be alternatively connected by using another conducting structure such as a lead.

In another implementation, as shown in FIG. 12, when the conductor is a lead frame 15, the lead frame 15 is provided. The lead frame 15 includes a first terminal 151, a second terminal 152, and a third terminal 153 that are connected to each other, and the first terminal 151 is electrically connected to the second terminal 152 and the third terminal 153. In this embodiment, there are two lead frames 15. The first terminal 151 of the lead frame 15 is electrically connected to a power chip 112 corresponding to the lead frame 15, and the third terminal 153 is connected to a second line a22 corresponding to the lead frame 15, so that the lead frame 15 is connected to a pin 114 corresponding to the lead frame 15 through the second line a22. The second terminal 152 is configured to connect to a related element in a subsequent process. In addition, the two power chips 112 can be further electrically connected through the lead frame 15.

When the conductor is the lead frame 15, the lead frame 15 implements both an electrical connection between the pin 114 and the power chip 112 and an electrical connection between the two power chips 112, so that no additional lead needs to be introduced to connect the power chip 112 and the pin 114 and connect the two power chips 112. Therefore, a structure of the power module is simpler, and manufacturing steps of the power module are reduced, thereby improving production efficiency of the power module. In addition, compared with a lead, the lead frame 15 has a stronger through-current capability and a smaller parasitic parameter, so that heat dissipation effect of the power chip 112 can be further improved.

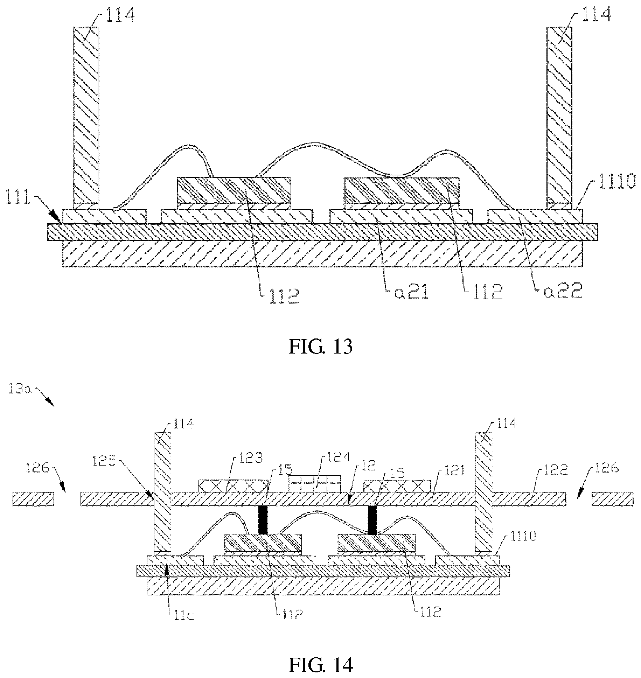

Certainly, in another embodiment, as shown in FIG. 13, which does not fall within the scope of the claimed invention, no conductor needs to be formed on the surface, of the power chip 112, that backs the mounting surface 1110, and a lead is used to directly connect the power chip 112 to the pin 114, and connect the two power chips 112. Alternatively, another conducting structure is used to directly connect the power chip 112 to the pin 114, and connect the two power chips 112.

S120: Provide a drive board 12, dispose the drive board 12 on a side, of the power chip 112, that backs the mounting surface 1110, and electrically connect the drive board 12 to the power chip 112, to form a to-be-packaged structure 13a.

Specifically, as shown in FIG. 14 to FIG. 16, all of which do not fall within the scope of the claimed invention, first, the drive board 12 is provided. In this embodiment, as shown in FIG. 14, the drive board 12 includes a center region 121 and an edge region 122 surrounding the center region 121. Electronic elements such as a drive chip 123, a resistor 124, a capacitor, and an optocoupler are disposed in the center region 121 to form a drive circuit. The drive board 12 further includes a through hole 125 and a via 126. The through hole 125 is located in the center region 121, and the via 126 is located in the edge region 122. Certainly, in another embodiment, small electronic elements such as the resistor 124, the capacitor, and the optocoupler may be alternatively partially disposed in the edge region 122. Alternatively, the drive board 12 may include only the center region 121, that is, the drive board 12 may not include the edge region 122.

Then the drive board 12 is disposed on the side, of the power chip 112, that backs the mounting surface 1110, and the drive board 12 is electrically connected to the power chip 112, to form the to-be-packaged structure 13a. Specifically, the drive board 12 is disposed between two ends of the pin 114, and is close to an end, of the pin 114, that is electrically connected to the power chip 112. The drive board 12 is required to be disposed close to the end, of the pin 114, that is electrically connected to the power chip 112, to ensure that a distance between the drive board 12 and the power chip 112 is sufficiently short, thereby ensuring that a parasitic parameter of a connection line between the drive board 12 and the power chip 112 is sufficiently small, and effectively improving electrical performance of the power module.

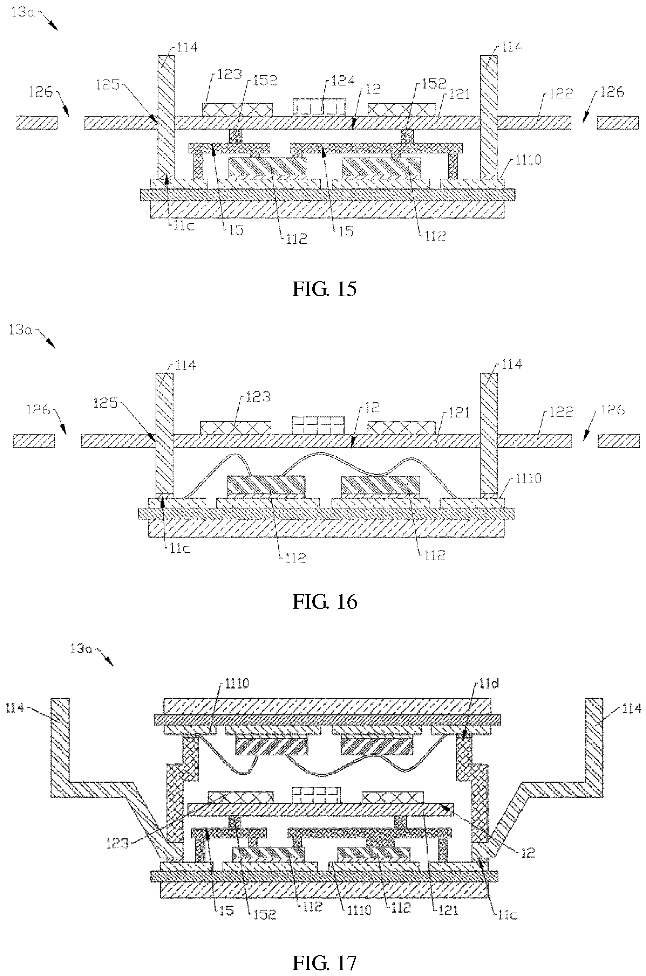

Specifically, this step may be implemented in a plurality of manners. In an implementation, in a scenario in which the copper rod 15 or the lead frame 15 is disposed on the surface, of the power chip 112, that backs the mounting surface 1110, as shown in FIG. 14 and FIG. 15, first, the drive board 12 is disposed at an end, of the copper rod 15, that backs the power chip 112 or is disposed at the second terminal 152 of the lead frame 15, the center region 121 is arranged opposite to the first power board 11c, and the pin 114 passes through the through hole 125 on the drive board 12 and is connected to the drive board 12 in an insulated manner. Then the end, of the copper rod 15, that backs the power chip 112 or the second terminal 152 of the lead frame 15 is welded to the drive board 12, so that the drive chip 123 on the drive board 12 is electrically connected to the power chip 112 through the conductor 15, to form the to-be-packaged structure 13a.

In this implementation, a length of the copper rod 15 is equal to the distance between the drive board 12 and the power chip 112. It may be understood that a length direction of the copper rod 15 is a flow direction of a current in the copper rod 15, so that the length of the copper rod 15 is the shortest, that is, the connection line between the drive board 12 and the power chip 112 is the shortest, thereby effectively reducing the parasitic parameter of the connection line of the power module, and improving electrical performance of the power module.

In another implementation, in a scenario in which no copper rod 15 or lead frame 15 is disposed on the surface, of the power chip 112, that backs the mounting surface 1110, as shown in FIG. 16, first, the drive board 12 is disposed on a side, of the power chip 112, that backs the mounting surface 1110, the center region 121 is arranged opposite to the first power board 11c, and the pin 114 passes through the through hole 125 on the drive board 12. Then a hole wall of the through hole 125 is electrically connected to the pin 114, so that the drive chip 123 on the drive board 12 is electrically connected to the power chip 112 through the pin 114, to form the to-be-packaged structure 13a.

In another embodiment, the drive board 12 includes only the center region 121, a copper rod or a lead frame is disposed on the surface, of the power chip 112, that backs the mounting surface 1110, and the pin 114 is not perpendicular to the mounting surface 1110. In this scenario, as shown in FIG. 17, which does not fall within the scope of the claimed invention, an example in which the lead frame 15 is disposed on the surface, of the power chip 112, that backs the mounting surface 1110 is used for description in FIG. 17. First, the drive board 12 is disposed at the second terminal 152 of the lead frame 15, and the center region 121 is arranged opposite to the first power board 11c and is located between two pins 114. Then the second terminal 152 of the lead frame 15 is welded to the drive board 12, so that the drive chip 123 on the drive board 12 is electrically connected to the power chip 112 through the lead frame 15. Finally, a second power board 11d is provided. Structures of the second power board 11d and the first power board 11c are basically the same. The second power board 11d is disposed on a side, of the drive board 12, that backs the first power board 11c, and is electrically connected to the first power board 11c, to form the to-be-packaged structure 13a. Specifically, a mounting surface 1110 of the second power board 11d is arranged opposite to the mounting surface 1110 of the first power board 11c. That is, the first power board 11c and the second power board 11d are symmetrically disposed on two sides of the drive board 12. Certainly, an arrangement manner of the pin 114, the drive board 12, the first power board, and the second power board is not limited to the foregoing descriptions. Alternatively, the power chip 112 may be connected to a circuit board by using a structure other than the pin 114.

S130: Package the to-be-packaged structure 13a by using a package body 113, to form a power module.

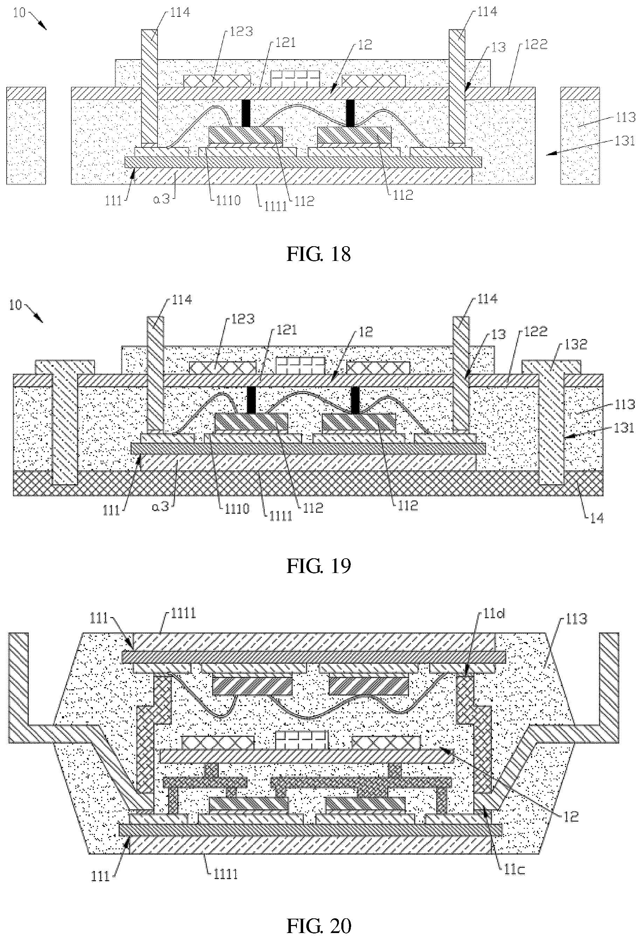

Specifically, as shown in FIG. 18 and FIG. 19, figure 18 which does not fall within the scope of the claimed invention but is useful for understanding the invention and figure 19 which falls within the scope of the claimed invention, the to-be-packaged structure 13a is packaged by using a plastic packaging process. The to-be-packaged structure 13a may be the to-be-packaged structure 13a shown in FIG. 14, FIG. 15, FIG. 16, and FIG. 17. An example in which the to-be-packaged structure 13a is the to-be-packaged structure 13a shown in FIG. 14 is used below for description. Specifically, first, the to-be-packaged structure 13a is placed in a package mold. An end, of the pin 114, that is away from the power chip 112 extends out of the package mold. An avoidance structure is disposed in the package mold, and the avoidance structure is located on a surface, of the edge region 122 of the drive board 12, that backs the power chip 112, and extends, through the via in the edge region 122, toward a plane on which the rear surface 1111 of the substrate 111 is located. Then the package mold is filled with the package body 113. The package body 113 is made of a plastic material such as epoxy resin. After being cured, the package body 113 forms the packaged structure 13 with the to-be-packaged structure 13a, so as to form the power module 10. Finally, the package mold is removed. In this embodiment, the power module 10 formed by using the plastic packaging process has good sealing performance, so that moisture resistance and reliability of the power module 10 can be improved.

In this embodiment, the package body 113 is packaged in a region from the rear surface 1111 of the substrate 111 to the side, of the drive board 12, that backs the power chip 112, and the end, of the pin 114, that is away from the power chip 112 is exposed from the package body 113, to be electrically connected to a related external device. According to the invention, the rear surface 1111 of the substrate 111 is exposed from the package body 113. Because the rear surface 1111 of the metal layer a3 is exposed from the package body 113, the metal layer a3 can effectively transmit heat of the power chip 112 to the outside, thereby improving heat dissipation efficiency of the power chip 112. In addition, the formed packaged structure 13 includes the via 126 formed by the avoidance structure avoiding the package body 113 and a mounting hole 131 of the package body 113, and a related component is connected to the packaged structure 13 through the mounting hole 131. A surface, of the edge region 122, that backs the power chip 112 is exposed from the package body 113, thereby facilitating fitting between the power chip 112 and a related structure.

In a direction perpendicular to the mounting surface 1110, a distance between the drive board 12 and the power chip 112 is less than a distance between the drive board 12 and a surface, of the package body 113, that backs the mounting surface 1110. In this embodiment, the distance between the drive board 12 and the power chip 112 is required to be less than the distance between the drive board 12 and the surface, of the package body 113, that backs the mounting surface 1110, to ensure that the distance between the drive board 12 and the power chip 112 is sufficiently short, thereby ensuring that the parasitic parameter of the connection line between the drive board 12 and the power chip 112 is sufficiently small, and effectively improving electrical performance of the power module 10.

Finally, as shown in FIG. 19, an embodiment falling within the scope of the claimed invention, a heat sink 14 is fastened to the packaged structure 13, and the heat sink 14 is in contact with the rear surface 1111 of the substrate 111, to improve heat dissipation efficiency of the power chip 112. A specific step of fastening the heat sink 14 to the packaged structure 13 is as follows: A screw 132 passes through the mounting hole 131 from the surface, of the edge region 122, that backs the power chip 112, and is tightened to the heat sink 14. No package body 113 is disposed on the surface, of the edge region 122, that backs the power chip 112, so that the screw 132 is fastened through the surface, of the edge region 122, that backs the power chip 112. In addition, the package body 113 is made of a brittle material, and the package body 113 is prone to breakage under large stress. Because no package body is disposed in the edge region 122, the screw 132 directly transmits a locking force to the drive board 12, thereby reducing the stress applied to the package body 113, and avoiding a risk that the package body 113 cracks because the screw 132 directly transmits the locking force to the package body 113. Certainly, in another embodiment, the heat sink 14 may be alternatively fastened to the packaged structure 13 by using a screw or in another fastening manner, but these would not fall within the scope of the present claimed invention.

As shown in FIG. 20, an embodiment which does not fall within the scope of the claimed invention, in which the to-be-packaged structure 13a (FIG. 17) includes a first power board 11c, a drive board 12, and a second power board 11d, after the to-be-packaged structure 13a is packaged by using the package body 113, rear surfaces 1111 of substrates 111 of the first power board 11c and the second power board 11d are both exposed from the package body 113, so that the substrates 111 of the first power board 11c and the second power board 11d are respectively connected to heat sinks corresponding to the rear surfaces 1111 of the substrates 111 of the first power board 11c and the second power board 11d, so as to implement good heat dissipation for the power module 10.

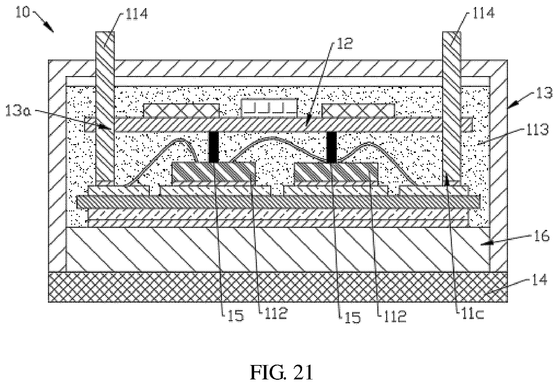

In another embodiment which does not fall within the scope of the claimed invention, as shown in FIG. 21, a specific method for packaging the to-be-packaged structure 13a by using the package body 113 may be alternatively as follows: First, a package housing 16 is provided, the to-be-packaged structure 13a is fastened in the package housing 16, and an end, of the pin 114, that is away from the mounting surface 1110 is exposed from the package housing 16. The to-be-packaged structure 13a may include a first power board 11c and a drive board 12 (as shown in FIG. 21), or may include a first power board 11c, a drive board 12, and a second power board. Then adhesive is injected into the package housing 16 to fill a gap in the package housing 16, so as to form the package body 113. The package body 113, the to-be-packaged structure 13a, and the package housing 16 jointly constitute the packaged structure 13, to form the power module 10. Specifically, silicon gel is injected into the package housing 16 to form the package body 113. In this embodiment, the package body 113 is formed by using a housing packaging process. The process is simple, thereby effectively improving production efficiency of the power module 10. In a scenario of this embodiment, the drive board 12 in the to-be-packaged structure 13a includes only a center region 121. The heat sink 14 is disposed on the package housing 16 to dissipate heat for the power module 10.

In the manufacturing method for the power module 10 in this disclosure, which does not fall within the scope of this claimed invention, the drive board 12 is disposed on the side, of the power chip 112, that backs the mounting surface 1110, the drive board 12 is electrically connected to the power chip 112 to form the to-be-packaged structure 13a, and then the to-be-packaged structure 13a is packaged to form the packaged structure 13. To be specific, the drive board 12 and the power chip 112 are packaged together, so that a distance between the drive board 12 and the power chip 112 can be shortened. Further, a connection line between the power chip 112 and the drive board 12 is shortened, thereby effectively reducing a parasitic parameter of the connection line between the power chip 112 and the drive board 12, that is, reducing a parasitic parameter of the power module 10, and improving electrical performance of the power module 10. In addition, the drive board 12 and the first power board 11c are packaged together. Compared with disposing the drive board 12 and the first power board 11c on a same plane, this can effectively reduce a planar area of the power module 10. During packaging of the first power board 11c, to ensure strength of the first power board 11c after packaging, a thickness of the first power board 11c after packaging is usually greater than 5 mm. This thickness is sufficient to allow the drive board 12 and the first power board 11c to be packaged together without increasing the thickness of the first power board 11c. That is, packaging the drive board 12 and the first power board 11c together does not affect the thickness obtained after packaging, thereby effectively improving integration of the power module 10, reducing a package size, and reducing costs of the power module 10.

The protection scope of this application shall be subject to the protection scope of the claims.

## Claims

1. A power module (10), wherein the power module (10) comprises a power assembly (11, 11a, 11b) and a drive board (12), the power assembly (11, 11a, 11b) comprises a substrate (111), a power chip (112), and a package body (113, 133), the package body (113, 133) is made of a plastic material, the power chip (112) is disposed on a mounting surface (1110) of the substrate (111), the package body (113, 133) packages the power chip (112) on the substrate (111), the drive board (12) is disposed in the package body (113, 133) and is located on a side, of the power chip (112), that backs the mounting surface (1110), and the drive board (12) is electrically connected to the power chip (112);
wherein the drive board (12) and the power assembly (11, 11a, 11b) constitute a packaged structure, a surface, of the substrate (111), that backs the power chip (112) is a rear surface (1111), the rear surface (1111) is exposed from the package body (113, 133), the power module (10) further comprises a heat sink (14), and the heat sink (14) is fastened to the packaged structure and is in contact with the rear surface (1111); and
wherein the drive board (12) comprises a center region (121) and an edge region (122) surrounding the center region (121), the center region (121) is arranged opposite to the power assembly (11, 11a, 11b), the packaged structure comprises a mounting hole (131), the mounting hole (131) is located in the edge region (122), and penetrates the drive board (12) and the package body (113, 133) in a direction from the drive board (12) to the power chip (112), and the heat sink (14) is connected to the packaged structure through the mounting hole (131); and
wherein a surface, of the edge region (122), that backs the power chip (112) is exposed from the package body (113, 133), so that a screw (132) is fastened through the surface, of the edge region (122), that backs the power chip (112).

2. The power module (10) according to claim 1, wherein in a direction perpendicular to the mounting surface (1110), a distance between the drive board (12) and the power chip (112) is less than a distance between the drive board (12) and a surface, of the package body (113, 133), that backs the mounting surface (1110).

3. The power module (10) according to claim 1 or 2, wherein the power assembly (11, 11a, 11b) further comprises a pin (114), the pin (114) penetrates the drive board (12) and a part of the package body (113, 133), one end of the pin (114) is disposed on the mounting surface (1110) and is electrically connected to the power chip (112), and the other end of the pin (114) is exposed from the package body (113, 133).

4. The power module (10) according to claim 3, wherein the drive board (12) is electrically connected to the power chip (112) through the pin (114).

5. The power module (10) according to claim 3, wherein the power module (10) further comprises a conductor (15), the conductor (15) is located between the power chip (112) and the drive board (12), and the power chip (112) is connected to the drive board (12) through the conductor (15).

6. The power module (10) according to claim 5, wherein the conductor (15) is a copper rod (15), and two ends of the copper rod (15) are respectively electrically connected to the power chip (112) and the drive board (12).

7. A converter, wherein the converter comprises a circuit board and the power module according to any one of claims 1 to 6, and the power module is electrically connected to the circuit board.

8. An electronic device, wherein the electronic device comprises the converter according to claim 7, and the converter is configured to convert an electrical signal of the electronic device.

## Patentansprüche

1. Leistungsmodul (10), wobei das Leistungsmodul (10) eine Leistungsbaugruppe (11, 11a, 11b) und eine Treiberplatine (12) umfasst, die Leistungsbaugruppe (11, 11a, 11b) ein Substrat (111), einen Leistungschip (112) und einen Paketkörper (113, 133) umfasst, der Paketkörper (113, 133) aus einem Kunststoffmaterial hergestellt ist, der Leistungschip (112) auf einer Montageoberfläche (1110) des Substrats (111) angeordnet ist, der Paketkörper (113, 133) den Leistungschip (112) auf dem Substrat (111) verpackt, die Treiberplatine (12) in dem Paketkörper (113, 133) angeordnet ist und sich auf einer Seite des Leistungschips (112) befindet, die die Montageoberfläche (1110) stützt, und die Treiberplatine (12) elektrisch mit dem Leistungschip (112) verbunden ist;
wobei die Treiberplatine (12) und die Leistungsbaugruppe (11, 11a, 11b) eine verpackte Struktur darstellen, eine Oberfläche des Substrats (111), die den Leistungschip (112) stützt, eine hintere Oberfläche (1111) ist, die hintere Oberfläche (1111) von dem Paketkörper (113, 133) freigelegt ist, das Leistungsmodul (10) ferner einen Kühlkörper (14) umfasst und der Kühlkörper (14) an der verpackten Struktur befestigt ist und mit der hinteren Oberfläche (1111) in Kontakt steht; und wobei die Treiberplatine (12) einen Mittelbereich (121) und einen den Mittelbereich (121) umgebenden Randbereich (122) umfasst, der Mittelbereich (121) gegenüber der Leistungsbaugruppe (11, 11a, 11b) angeordnet ist, die verpackte Struktur ein Montageloch (131) umfasst, das Montageloch (131) sich in dem Randbereich (122) befindet und die Treiberplatine (12) und den Paketkörper (113, 133) in einer Richtung von der Treiberplatine (12) zu dem Leistungschip (112) durchdringt, und der Kühlkörper (14) mit der verpackten Struktur über das Montageloch (131) verbunden ist; und
wobei eine Oberfläche des Randbereichs (122), der den Leistungschip (112) stützt, von dem Paketkörper (113, 133) freigelegt ist, sodass eine Schraube (132) über die Oberfläche des Randbereichs (122), der den Leistungschip (112) stützt, befestigt ist.

2. Leistungsmodul (10) gemäß Anspruch 1, wobei in einer Richtung senkrecht zu der Montageoberfläche (1110) ein Abstand zwischen der Treiberplatine (12) und dem Leistungschip (112) geringer ist als ein Abstand zwischen der Treiberplatine (12) und einer Oberfläche des Paketkörpers (113, 133), die die Montageoberfläche (1110) stützt.

3. Leistungsmodul (10) gemäß Anspruch 1 oder 2, wobei die Leistungsbaugruppe (11, 11a, 11b) ferner einen Stift (114) umfasst, der Stift (114) die Treiberplatine (12) und einen Teil des Paketkörpers (113, 133) durchdringt, ein Ende des Stifts (114) auf der Montageoberfläche (1110) angeordnet und elektrisch mit dem Leistungschip (112) verbunden ist und das andere Ende des Stifts (114) von dem Paketkörper (113, 133) freigelegt ist.

4. Leistungsmodul (10) gemäß Anspruch 3, wobei die Treiberplatine (12) über den Stift (114) elektrisch mit dem Leistungschip (112) verbunden ist.

5. Leistungsmodul (10) gemäß Anspruch 3, wobei das Leistungsmodul (10) ferner einen Leiter (15) umfasst, der Leiter (15) sich zwischen dem Leistungschip (112) und der Treiberplatine (12) befindet und der Leistungschip (112) über den Leiter (15) mit der Treiberplatine (12) verbunden ist.

6. Leistungsmodul (10) gemäß Anspruch 5, wobei der Leiter (15) ein Kupferstab (15) ist und zwei Enden des Kupferstabs (15) jeweils elektrisch mit dem Leistungschip (112) und der Treiberplatine (12) verbunden sind.

7. Wandler, wobei der Wandler eine Leiterplatte und das Leistungsmodul gemäß einem der Ansprüche 1 bis 6 umfasst und das Leistungsmodul elektrisch mit der Leiterplatte verbunden ist.

8. Elektronische Vorrichtung, wobei die elektronische Vorrichtung den Wandler gemäß Anspruch 7 umfasst und der Wandler dazu konfiguriert ist, ein elektrisches Signal der elektronischen Vorrichtung umzuwandeln.

## Revendications

1. Module de puissance (10), dans lequel le module de puissance (10) comprend un assemblage de puissance (11, 11a, 11b) et une carte de commande (12), l'assemblage de puissance (11, 11a, 11b) comprend un substrat (111), une puce de puissance (112), et un corps de boîtier (113, 133), le corps de boîtier (113, 133) est fabriqué à partir d'un matériau plastique, la puce de puissance (112) est disposée sur une surface de montage (1110) du substrat (111), le corps de boîtier (113, 133) encapsule la puce de puissance (112) sur le substrat (111), la carte de commande (12) est disposée dans le corps de boîtier (113, 133) et est située sur un côté, de la puce de puissance (112), qui soutient la surface de montage (1110), et la carte de commande (12) est connectée électriquement à la puce de puissance (112) ;
dans lequel la carte de commande (12) et l'assemblage de puissance (11, 11a, 11b) constituent une structure encapsulée, une surface, du substrat (111), qui soutient la puce de puissance (112) est une surface arrière (1111), la surface arrière (1111) est exposée à partir du corps de boîtier (113, 133), le module de puissance (10) comprend également un dissipateur thermique (14), et le dissipateur thermique (14) est fixé à la structure encapsulée et est en contact avec la surface arrière (1111) ; et
dans lequel la carte de commande (12) comprend une région centrale (121) et une région périphérique (122) entourant la région centrale (121), la région centrale (121) est agencée à l'opposé de l'assemblage de puissance (11, 11a, 11b), la structure encapsulée comprend un trou de montage (131), le trou de montage (131) est situé dans la région périphérique (122), et pénètre dans la carte de commande (12) et le corps de boîtier (113, 133) dans une direction de la carte de commande (12) à la puce de puissance (112), et le dissipateur thermique (14) est connecté à la structure encapsulée par l'intermédiaire du trou de montage (131) ; et
dans lequel une surface, de la région périphérique (122), qui soutient la puce de puissance (112) est exposée à partir du corps de boîtier (113, 133), de sorte qu'une vis (132) est fixée à travers la surface, de la région périphérique (122), qui soutient la puce de puissance (112).

2. Module de puissance (10) selon la revendication 1, dans lequel, dans une direction perpendiculaire à la surface de montage (1110), une distance entre la carte de commande (12) et la puce de puissance (112) est inférieure à une distance entre la carte de commande (12) et une surface, du corps de boîtier (113, 133), qui soutient la surface de montage (1110).

3. Module de puissance (10) selon la revendication 1 ou 2, dans lequel l'assemblage de puissance (11, 11a, 11b) comprend également une broche (114), la broche (114) pénètre la carte de commande (12) et une partie du corps de boîtier (113, 133), une extrémité de la broche (114) est disposée sur la surface de montage (1110) et est connectée électriquement à la puce de puissance (112), et l'autre extrémité de la broche (114) est exposée à partir du corps de boîtier (113, 133).

4. Module de puissance (10) selon la revendication 3, dans lequel la carte de commande (12) est connectée électriquement à la puce de puissance (112) par l'intermédiaire de la broche (114).

5. Module de puissance (10) selon la revendication 3, dans lequel le module de puissance (10) comprend également un conducteur (15), le conducteur (15) est situé entre la puce de puissance (112) et la carte de commande (12), et la puce de puissance (112) est connectée à la carte de commande (12) par l'intermédiaire du conducteur (15).

6. Module de puissance (10) selon la revendication 5, dans lequel le conducteur (15) est une tige de cuivre (15), et deux extrémités de la tige de cuivre (15) sont respectivement connectées électriquement à la puce de puissance (112) et à la carte de commande (12).

7. Convertisseur, dans lequel le convertisseur comprend une carte de circuit imprimé et le module de puissance selon l'une quelconque des revendications 1 à 6, et le module de puissance est connecté électriquement à la carte de circuit imprimé.

8. Dispositif électronique, dans lequel le dispositif électronique comprend le convertisseur selon la revendication 7, et le convertisseur est configuré pour convertir un signal électrique du dispositif électronique.
